# EUROPEAN PATENT SPECIFICATION

(11) **EP 0 784 799 B1**
(45) Date of publication and mention of the grant of the patent: **25.11.1998**
(21) Application number: 95932598.6
(22) Date of filing: 03.10.1995
(51) Int. Cl.: G01R 31/26

(54) **BUS FOR SENSITIVE ANALOG SIGNALS**
BUS FÜR EMPFINDLICHE ANALOGE SIGNALE
BUS POUR SIGNAUX ANALOGIQUES SENSIBLES

(30) Priority: 06.10.1994 US 318950
(43) Date of publication of application: 23.07.1997
(73) Proprietor: NORTHERN TELECOM LIMITED, Montreal, Quebec H2Y 3Y4 (CA)
(72) Inventor: SUNTER, Stephen, Kenneth, Nepean, Ontario K2H 6J2 (CA)
(74) Representative: Berkson, Michael David
(86) International application number: CA9500560
(87) International publication number: WO9611411

(56) References cited:
- EP-A- 0 159 907
- EP-A- 0 434 137
- EP-A- 0 602 973
- FR-A- 2 622 753

## Description

### Field of Invention

This invention relates to a testability structure and more particularly to an analog test access bus for analog or mixed analog/digital integrated circuits (ICs).

### Background of the Invention

As the complexity of integrated circuits increases the ability to carry out extensive performance testing immediately after fabrication and in service becomes increasingly more critical. In digital integrated circuits, logic levels are in one of two modes: high or low, and hence the ramifications of applying test conditions to such circuits are less severe. Consequently, test procedures for digital circuits are well developed. Analog circuits, on the other hand, are influenced by analog elements such as capacitance, resistance, inductance, etc. Therefore, testability structure which permits any of these elements to be introduced to a test node on an analog circuit will result in inaccurate test data. In an integrated circuit it is known to employ an analog bus to convey signals originating inside the IC to an output pin for evaluation.

### Prior Art

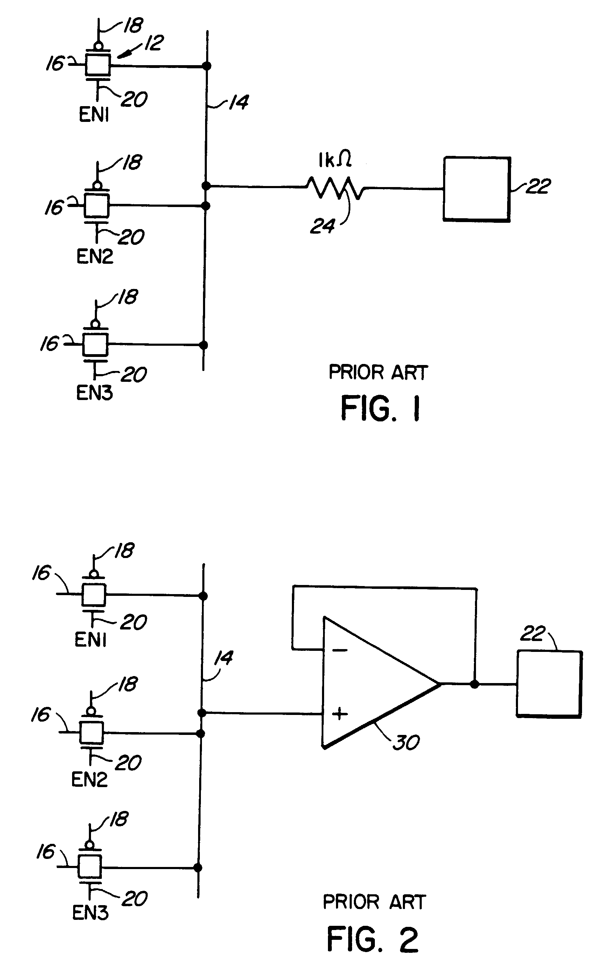

One known structure for testing analog signals is illustrated in FIGURE 1. The structure comprises one or more on-chip CMOS transmission gates which convey the test signals off chip through an electro-static discharge (ESD) protection network. A tester is connected either directly to the test pad or to the test pad via an off-chip amplifier (not shown). This structure is relatively simple and consumes little extra silicon area on the IC. The bandwidth is limited primarily by the output impedance of the source node under test, the resistance of the transmission gate, the resistance of the ESD network and any off-chip capacitances. With no off-chip amplifier, the structure is highly linear. The transmission gate has a non-linear resistance but its effect is usually negligible unless current flow becomes significant.

The structure has, however, several disadvantages. Most importantly, when the node of interest is connected to the bus, the node is subjected to an increase in capacitance which is equal to that of the entire bus. In many applications this capacitance is significantly larger than that which the node of interest normally drives. This significant change in capacitance means that the circuit designer must simulate both loading conditions to ensure correct operation. Further, the bus loading can change depending on off-chip connections. An additional disadvantage of this structure is that the bandwidth is limited and may be only several MHz for practical resistances, say, 1KΩ - 5KΩ and capacitances of 20pF - 50pF. The structure of FIGURE 1 is further described by Parker et al - Proceedings of IEEE International Test Conference, October 1993, pp. 309-20 entitled "Structure and Metrology for an Analog Testability Bus".

A second structure according to the prior art is illustrated in FIGURE 2. In this configuration the signal of interest is connected to the analog bus via a CMOS transmission gate and conveyed off-chip using an operational amplifier as a buffer to provide low impedance drive and isolation between the off-chip load and the sensitive on-chip signal of interest. For more details concerning this configuration, reference may be made to Van Peteghem et al - IEEE Journal of Solid State Circuits, Vol. 24, pp. 540-42, April 1989, "Compact High-Frequency Output Buffer for Testing of Analog CMOS VLSI Circuits".

As in the previous structure the configuration of FIGURE 2 offers simplicity and relatively little extra silicon area. The bandwidth is limited primarily by the operational amplifier. Since operational amplifiers are known to be very linear the structure provides high linearity as the transmission gates' non-linear resistance can be ignored due to the lack of any significant current flow. To obtain high bandwidth, however, high bandwidth operational amplifiers are required and these consume both more current and silicon area. It is common, of course, for the integrated circuit to require a high bandwidth operational amplifier for normal operation and hence it can be made available for use in test mode as the analog bus buffer. Unfortunately, this prevents simultaneous monitoring of on-chip signals and the normal mode output of the operational amplifier. If simultaneous monitoring is a requisite then a dedicated operational amplifier with concomitant disadvantages must be incorporated on chip.

The structure of FIGURE 2 has other disadvantages similar to those discussed with respect to the structure of FIGURE 1. As in the previous case, connection of a node of interest to the analog bus results in the full capacitance of the entire bus being imposed on the node. In many applications this capacitance is significantly larger than that which the node of interest normally drives though much less than in the previously discussed structure. As before, this change in capacitance means that the circuit designer must simulate both loading conditions to ensure correct operation. Fortunately, both loading conditions are accurately predictable before the IC is fabricated. Also, the bandwidth may be limited to several MHz, especially for low power ICs for which a high speed operational amplifier would draw too much power. If normal function of the IC requires a high speed operational amplifier then the bandwidth will be larger and may only be limited by the drive of the node of interest.

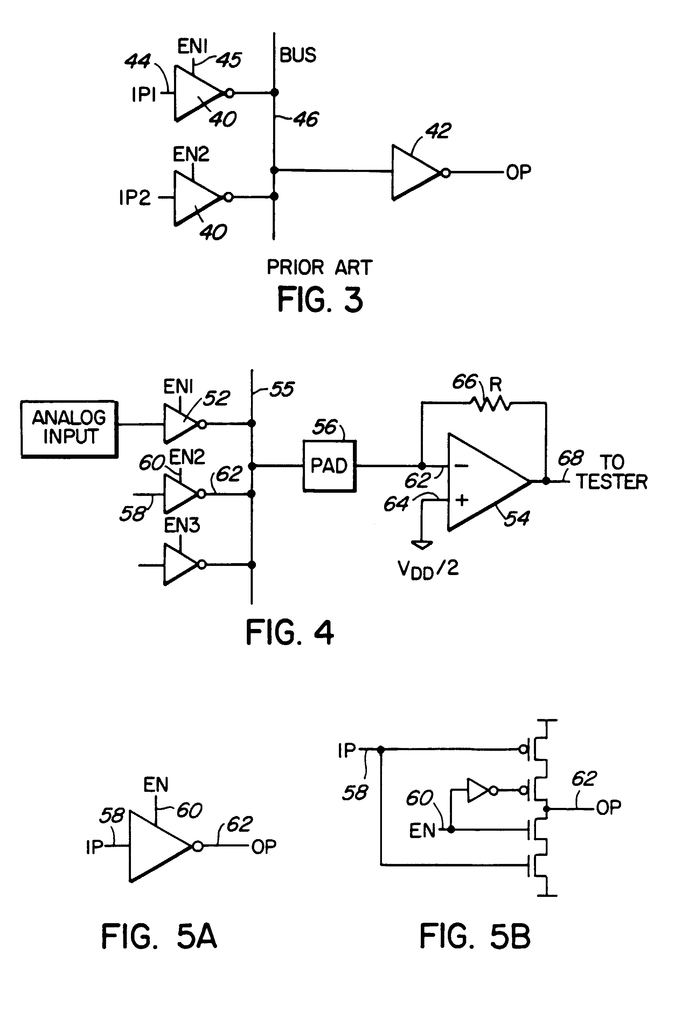

A structure which is particularly applicable to a digital bus is shown in FIGURE 3. This circuit uses 3-state digital converters as transmitters and an inverter as a receiver. In this discussion a 3-state inverter has three modes: 0, 1 and high impedance. Both the transmitting and receiving inverters typically have a voltage gain of between five and ten. If an analog signal is provided to the transmitting inverter, it will amplify the signal. The receiving inverter will amplify it further. To allow rail-to-rail signals on the input, the input signal needs to be attenuated or else unity gain inverters used. Logic inverters with unity gain have very little drive and greatly reduced bandwidth. Logic inverters with large enough drive to achieve good voltage output bandwidth draw excessive current when their input is mid-way between power supply voltages.

The structure of FIGURE 3 is inherently unsuitable for analog signal transmission. Both the transmitters and receiver are designed for driving either a logic 0 or logic 1 and consume excessive current when driving signals in between those levels. Drivers weak enough to draw small current have insufficient bandwidth.

In view of the foregoing there is a specific requirement for an analog bus which has a large bandwidth, does not introduce extra capacitance on the node of interest and, consequently, does not result in a change of capacitance on the node of interest when switching between test mode and normal operation mode.

### Summary of the Invention

It is an object of the present invention to provide an analog bus which offers a wide bandwidth limited primarily by the capability of off-chip components.

It is a further object of the invention to provide an analog bus which does not introduce significant extra capacitance to the node of interest relative to the capacitance normally driven by the node.

It is yet a further object of the invention to provide an analog bus which does not introduce a change in capacitance to the node of interest when switching between test mode and normal operation mode.

Additionally, the structure of the present invention seeks to provide reduced interaction between the analog bus and non-related signals on the IC.

Finally, it is an object of the invention to provide the aforementioned improvements and objects without increasing the silicon area relative to the structures of the prior art.

Therefore in accordance with a first aspect of the present invention there is provided an analog testability structure for use in testing analog signals in an integrated circuit. The structure comprises a voltage to current inverter having a first input for receiving an analog signal from a node of interest on the integrated circuit, a second input for receiving an enabling signal and output means for providing an analog test signal when an enabling signal is supplied to the second input. The structure also has a common bus connected to the output means. An amplifier is connected to the common bus which provides a test output proportional to the analog test signal. The amplifier is adapted to maintain the bus at a substantially constant voltage.

In accordance with a second aspect of the invention there is provided a method of accessing an analog signal at a node of interest in an integrated circuit. The integrated circuit includes a 3-state inverter with first and second inputs and an output; the first input being connected to the node of interest and the output to a common bus. According to the method an enable signal is selectively provided to the second input so that the analog signal at the node of interest is selectively transferred to the common bus via the inverter output. The common bus is connected to an operational amplifier having first and second amplifier inputs and an amplifier output. The first amplifier input is connected to the bus and the second amplifier input is connected to a reference voltage. The amplifier output is connected back to the common bus by way of a feedback path. The analog signal is accessed at the output of the operational amplifier.

### Brief Description of the Drawings

The invention will now be described in greater detail with reference to the attached drawings wherein:
FIGURE 1 is a circuit diagram of a prior art analog bus;
FIGURE 2 is a circuit diagram of an analog bus with on-chip buffer amplifier;
FIGURE 3 is a circuit diagram of a digital bus using 3-state digital bus drivers;
FIGURE 4 is an analog bus according to a first embodiment of the present invention;
FIGURE 5A is a 3-state inverter symbol;
FIGURE 5B is a 3-state inverter schematic in CMOS;
FIGURE 6 shows voltage out vs. voltage in curves for a CMOS inverter;
FIGURE 7 illustrates current out vs. voltage in curves for the CMOS inverter covered by FIGURE 6;
FIGURE 8 is the operational amplifier typical voltage out vs. inverter voltage in for the structure of FIGURE 4;
FIGURE 9 is a circuit diagram of a structure wherein protection resistors have large impedance;
FIGURE 10 is a circuit diagram illustrating a differential implementation of the invention;
FIGURE 11 is a circuit diagram of a simplified inverter for voltage to current conversion; and
FIGURE 12 is a circuit diagram of an embodiment utilizing a single transistor for voltage to current conversion.

### Detailed Description of the Invention

FIGURES 1 to 3 illustrate bus configurations according to the prior art. In FIGURE 1, transmission gates 12 are connected to the common bus 14. Each transmission gate 12 has input 16 to receive an analog test signal from a node of interest (not shown). Complementary P and N MOS transistors 18,20 on each gate 12 are selectively provided with an enabling signal when the transmission gate is to be activated in test mode. Upon activation the signal from the node of interest is transferred through the gate to the common bus 14. The test signal appears at test pad 22 via protection resistor 24. As discussed previously this structure has several disadvantages, particularly with respect to the capacitance reflected on the node of interest when the gate is turned on and the node is connected to the bus.

FIGURE 2 illustrates a variation on the circuit of FIGURE 1 wherein an operational amplifier (op-amp) 30 is connected between the common bus 14 and the test pad 22. The op-amp 30 which is on the integrated circuit may be either dedicated for test mode or may be an op-amp which is a required component of the integrated circuit function and multiplexed between normal operation and test mode. The disadvantages of this structure have also been discussed previously.

FIGURE 3 is a circuit diagram of a known bus for use in testing digital circuits. The configuration utilizes 3-state inverters 40 as transmitters and an inverter 42 as a receiver. The output to the test pad (not shown) is taken from the output of the receiver. The digital signal from the node of interest is supplied to input 44 of inverter 40. An enable signal is applied to input 45 when the test signal is to be coupled to the common bus 46. This structure is designed for digital circuits and is not suitable for testing analog signals.

The basic circuit of the present invention, as shown in FIGURE 4 is, an adaptation of the digital bus illustrated in FIGURE 3. 3-state "digital" inverter or bus drivers 52 are located on the integrated circuit while op-amp 54 is preferably off-chip for reasons to be discussed later. It is to be understood, however, that a testability bus with op-amp on chip is within the scope of the invention.

As shown in FIGURE 4, the 3-state inverters 52 are connected to the common on-chip bus 55 and to pad 56 via protection resistor (not shown). Each 3-state inverter as seen in FIGURE 5B preferably comprises a pair of CMOS transistors which provides a single stage of amplification. The analog test signal from the node of interest of the IC is connected to input 58 and an enable signal in the form of a logic 0 or logic 1 is selectively supplied to enable input 60. The testability signal is supplied by output 62 only when input 60 is enabled. FIGURE 5A shows the 3-state inverter symbol as used elsewhere in the illustrations.

Referring to FIGURE 4, op-amp 54 has one input 62 connected to pad 56 and the second input 64 tied to V_{DD}/₂. Resistor 66 is connected between op-amp output 68 and the first input 62. Resistor 66 supplies current back to the bus 55 and this current is directly proportional to the current supplied by the 3-state inverter. As a consequence the bus voltage is held constant at V_{DD}/2 independent of the signal on the bus 55.

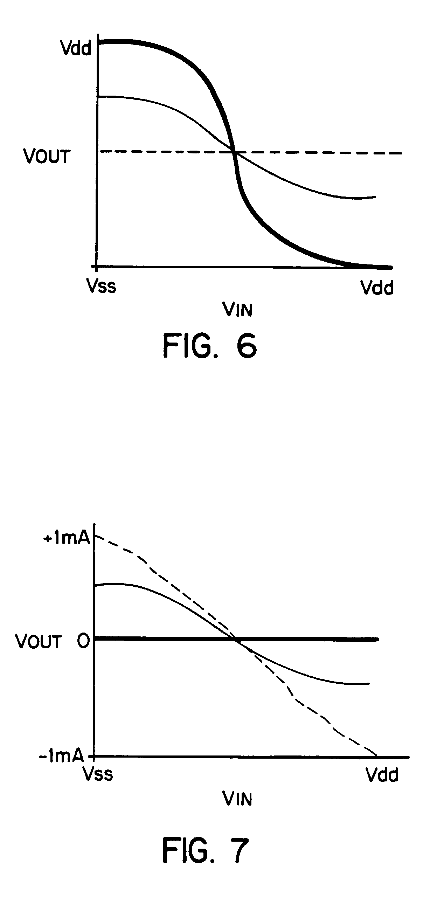

The current delivered by a typical CMOS inverter is approximately linear with respect to its input voltage as shown in FIGURE 7. FIGURE 6 shows the relationship of voltage out vs. voltage in for the same CMOS converter. In FIGURE 6, the heavy dark line is the non-loaded condition, the solid line represents the condition with the output connected via a resistor to VDD/2, and the dotted line is with the output shorted to V_{DD}/₂. In FIGURE 7 the heavy solid line shows the current output with no load, the solid line is the current through a resistor connected to V_{DD}/₂ and the dotted line is the current with the output connected directly to VDD/2.

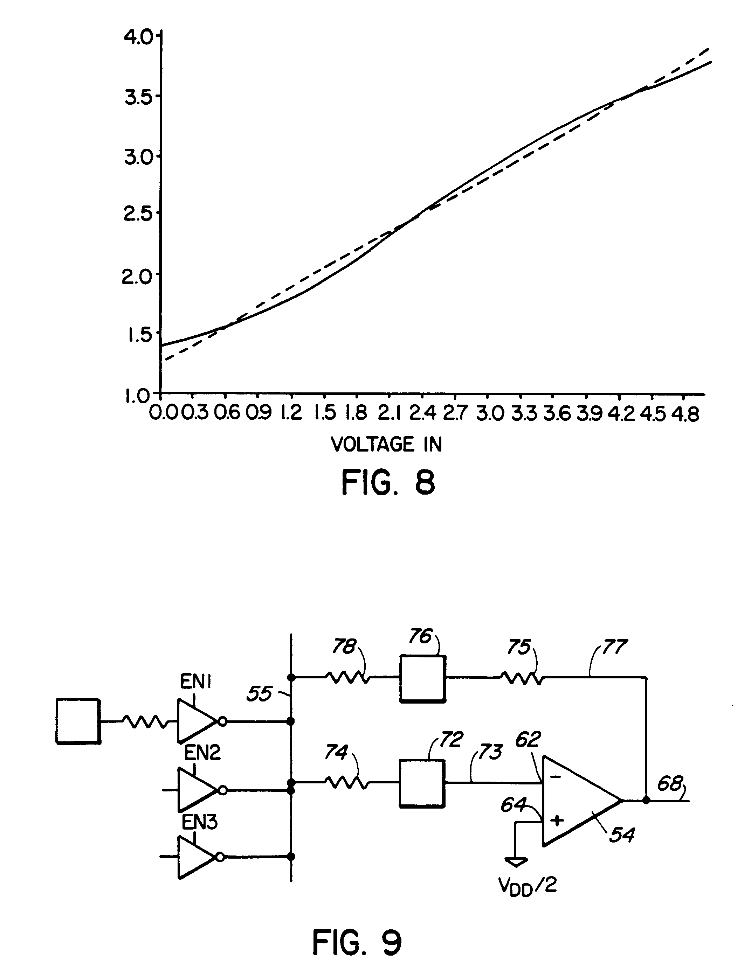

As shown the current delivered by the CMOS 3-state inverter is only approximately proportional to the input voltage. The non-linearity of the transfer function is typically less than 5% which is suitable for many test applications where only a verification that a signal is sinusoidal or square is sufficient. In this regard, the solid line of FIGURE 8 shows the relationship of the op-amp voltage out vs. inverter voltage in. This non-linearity is not acceptable for certain critical applications in which case the circuit shown in FIGURE 4 may be used to improve linearity. More specifically, one of the 3-state inverters is used to calibrate the non-linearity and gain of the signal path. The input to this inverter is connected to a calibration input pad which can be driven by a known signal.

While enabled, this path is driven by, say, a ramp from minimum (Ground or V_{SS}) to maximum (Power or V_{DD}) voltage. The output, slightly S-shaped, ramp is stored in the memory of an automatic test equipment (ATE) which uses digital signal processing (DSP), and a conversion algorithm is created for all signals later received from other 3-state inverters on the bus. For example, a piece-wise linear approximation can be done. After sampling the output from the 3-state inverter connected to a node of interest, each sample is compared to the points in the piece-wise linear model, and a new, more accurate, sample value is generated. After all samples (typically between 128 and 4096 samples are required for DSP analysis) have been converted to their "corrected" values, the normal DSP algorithms to determine harmonic distortion gain, signal-to-noise, etc., can be applied. A 10-segment piece-wise linear model is sufficient to achieve approximately 0.2% non-linearity for the example shown in FIGURE 8. An alternative is to use a best-fit third order polynomial (y=ax³+bx²+cx+d). The practical limit to this or any improvement in linearity is determined by the matching in transfer characteristics between the inverter used for calibration and the inverter used to observe the node of interest, and by the voltage range used. If a reduced voltage swing is tolerable, i.e., V_{SS}+Vₜₕ to V_{DD}-Vₜₕ, (Vₜₕ is the threshold voltage for the MOS transistors) then the best-fit straight line for that range gives typically less than 1% distortion before piece-wise linear calibration.

It is standard practice in IC technology to provide an electro-static discharge protection network resistance at each input/output pad. The analog bus structure of the present invention can be implemented in different ways depending on the value of the protection resistance. For protection resistances which are much less than the effective output impedance of the inverter, a single bonding pad 56 is sufficient to allow the analog bus voltage to be kept reasonably constant. This is shown in FIGURE 4. If, however, the resistance required for sufficient ESD protection is comparable to the inverter impedance two bonding pads are required as illustrated in FIGURE 9. One pad 72 and protection resistor 74 is in the "sense" path 73 which is connected to the op-amp input 62. Since the op-amp 54 typically has a very high input impedance substantially no current flows through this path. The other pad 76 and protection resistor 78 are in the "force" path 77, i.e., connected to the op-amp output 68, and forms part or all of the resistance used to convert the bus current to a voltage. For the most accurate results, the two paths, i.e., force 77 and sense 73, should be at opposite ends of the analog bus 55.

The operational amplifier may be integrated on-chip and for certain applications, especially if the op-amp is required for normal functions, such a structure is preferred. The advantages with respect to bandwidth, capacitance "seen" by the node of interest, etc., remain the same. On-chip integration, however, does not allow for improved performance which may be gained through advances in off-chip circuitry.

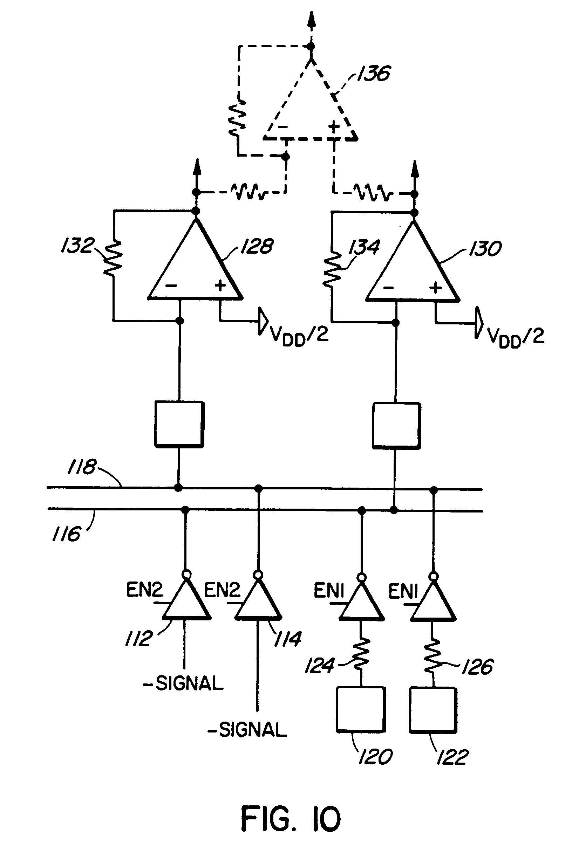

FIGURE 10 illustrates an embodiment of the invention wherein the circuit is fully differential. As shown two 3-state inverters 112,114 are connected to two separate analog busses 116,118. Two separate nodes of interest are connected to the test signal inputs of the two inverters. These signals of interest may be +signal and -signal or signal and local ground. A common enable signal is used to ensure that both nodes are examined at the same time. The circuit of FIGURE 10 may also have separate calibrate input pads 120,122 with associated protection resistances 124,126. The output of each 3-state inverter 112,114 is supplied to separate op-amps 128,130 via the separate analog buses 116,118 as shown in FIGURE 10. A resistor 132,134 connected from the output of each op-amp 128,130 to the appropriate input converts voltage to current which is supplied back to the individual busses as previously discussed. The configuration of FIGURE 10 may also have force and sense paths as described in relation to FIGURE 9.

The output of each op-amp 128,130 may be tested individually or the two outputs may be connected to a third op-amp 136 as shown in phantom in FIGURE 10 for a fully differential output.

Referring again to FIGURE 4, three 3-state inverters are shown, one for a calibration input and the other two for independently receiving test signals from nodes of interest. As a variation it is also possible to use a common enable signal on the two 3-state inverters connected to nodes of interest so that both are enabled at the same time and each provides an output onto the single common bus. In this case the arithmetic sum of their current outputs is delivered to the op-amp. This can be useful for observing the sum of the two components of a differential signal, for example, since the sum should always be equal to a D.C. voltage, unless a fault exists.

The 3-state inverters of FIGURE 4 will conventionally have similar characteristics although it is also within the scope of the present invention to design the inverters with different drive capabilities. In this way the two inverters previously described as being connected to a common bus can be calibrated separately and used to achieve different bandwidth and/or power trade-offs.

One of the important aspects of the present invention is that the extra capacitance seen by the node of interest when connected to a 3-state inverter is essentially constant, independent of the state of the inverter. The isolation between the inverter input and other signals on the analog bus is improved by placing the enable transistors between the inverter output and the input transistors as shown in FIGURE 5B. The isolation is also improved by the fact that the analog bus voltage is essentially constant. The inverter input capacitance can be made exceedingly small, though the noise figure of the transistor and matching to other transistors will be compromised.

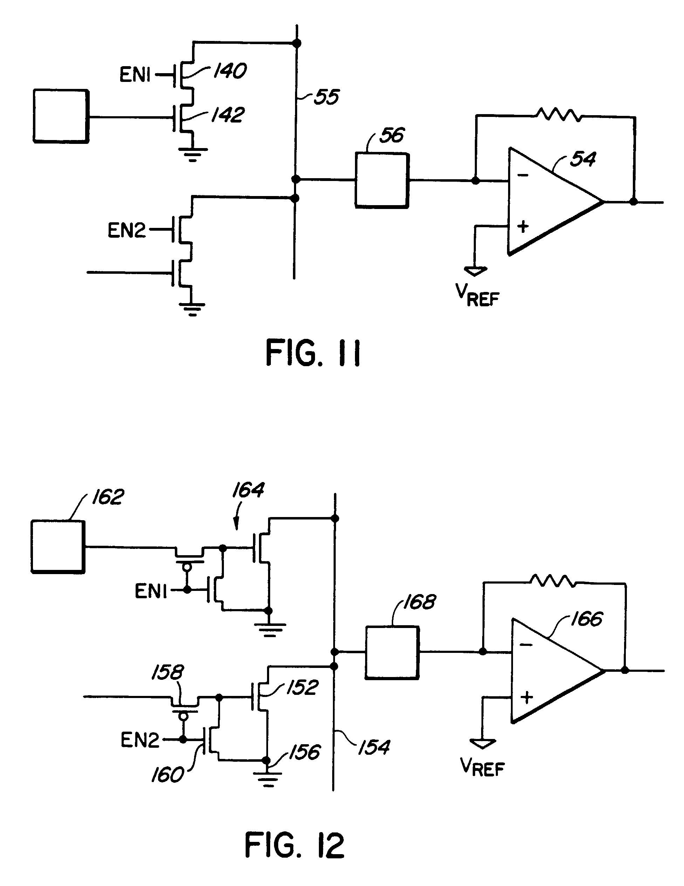

A further embodiment of the invention is shown in FIGURE 11. In this structure the CMOS inverter is simplified by using only NMOS transistors 140,142. It is to be understood, of course, that the structure may be altered to use only PMOS transistors although this is not shown in FIGURE 11. The operation of this structure is similar to the operation of the previously described structures but several advantages and one disadvantage are realized. The number of transistors is reduced from 6 to 2 (excluding the control register) which saves silicon area. Further, the input capacitance is reduced by approximately 50% and the bandwidth is improved because all the current is delivered to the op-amp. The current required from the on-chip power supply for NMOS (ground in the case of PMOS) is eliminated, latch-up robustness is improved because only one type of transistor is used, and the analog bus voltage can be changed in value so that the transistors operate in a more linear mode. The one disadvantage is the reduced voltage swing that can be tolerated at the input. Input voltages less than the threshold voltage of the NMOS transistor cannot be converted. It is possible, however, to make NMOS (or PMOS) transistors with reduced threshold voltages, which would increase the voltage range of this simplified structure.

FIGURE 12 illustrates an embodiment of the invention which may prove faster in some applications where bus capacitance significantly affects frequency response. As shown in FIGURE 12 a single transistor 152 is positioned between the common bus 154 and the ground supply 156. In the illustrated embodiment an N-type transistor is used to convert voltage to current, it being understood that a PMOS transistor can be substituted for the NMOS device to allow connection to V_{DD}. In either case complementary MOS devices 158,160 are used to process the enable signal. As a further alteration to this embodiment both the PMOS and NMOS based circuits can be combined into one to allow rail to rail swing on the input signal. The embodiment of FIGURE 12 also includes a test pad 162 and the calibration inverter 164 and op-amp 166 as previously discussed in relation to other embodiments.

Although specific embodiments of the invention have been illustrated and disclosed, it will be apparent to one skilled in the art that circuit variations and modifications can be implemented without departing from the scope of the invention as defined by the appended claims.

## Claims

1. An analog testability structure for use in testing analog signals in an integrated circuit, said structure comprising:
a single stage voltage to current converter (52) without feedback having a first input (58) for receiving an analog signal from a node of interest in said integrated circuit, a second input (60) for receiving an enabling signal and output means (62) for providing an analog test signal current when an enabling signal is supplied to said second input;
a common bus (55) connected to said output means; and
an amplifier circuit (54) connected to said common bus providing a test output (68) having a current which is proportional to said analog test signal current, characterised in that said amplifier circuit is adapted to maintain said bus at a substantially constant voltage.

2. A structure as defined in claim 1, said voltage to current converter (52) being a 3-state inverter.

3. A structure as defined in claim 2, having a plurality of 3-state inverters each having a first input for receiving analog signals from a plurality of nodes of interest in said integrated circuit.

4. A structure as defined in claim 2, said 3-state inverter comprising two pairs of complementary MOS transistors, one of said pair receiving test data and the other receiving said enabling signal.

5. A structure as defined in claim 2, said 3-state inverter comprising a pair of NMOS transistors.

6. A structure as defined in claim 2, said 3-state inverter comprising a pair of PMOS transistors.

7. A structure as defined in claim 2, said amplifier circuit being an operational amplifier (54) and a feedback resistor (66).

8. A structure as defined in claim 7, said operational amplifier having a first input (62) to receive said analog test signals, a second input (64) to receive a reference signal, and an output (68) to provide said test output.

9. A structure as defined in claim 2, said amplifier circuit being on said integrated circuit.

10. A structure as defined in claim 8, said analog test signals provided to said first input via an input path connected to said bus, said output connected to said bus via a feedback path.

11. A structure as defined in claim 10, wherein said input path and said feedback path are connected at opposite ends of said common bus.

12. A structure as defined in claim 2, having a plurality of 3-state inverters, one of said inverters receiving a calibration signal for comparison with said analog signal from a node of interest.

13. A structure as defined in claim 3, having first and second common busses (116,118) and a differential amplifier circuit (136) having a positive signal input, a negative signal input and a differential amplifier output wherein the output of one of said 3-state inverters (112) is connected to said first common bus (116) and the output of another of said 3-state inverters (114) is connected to said second common bus (118), said first common bus connected to said positive signal input of said differential amplifier circuit (136) and said second common bus connected to said negative signal input of said differential amplifier circuit so that the output of said differential amplifier circuit is proportional to the difference between the current on said first common bus and the current on said second common bus.

14. A structure as defined in claim 3 wherein first and second 3-state inverters are connected to said common bus, said first 3-state inverter receiving an analog signal from a first node of interest and said second 3-state inverter receiving an analog signal from a second node of interest, both of said 3-state inverters receiving the same enable signal and the output of said first and second inverters combined to generate an arithmetic sum of said analog test signals.

15. A structure as defined in claim 14, wherein said first and second 3-state inverters each have separate calibration inputs.

16. A structure as defined in claim 2, said 3-state inverter having a single NMOS transistor between the common bus and a ground connection.

17. A structure as defined in claim 2, said 3-state inverter having a single PMOS transistor between the common bus and a positive supply.

18. A method of accessing an analog signal at a node of interest in an integrated circuit, said integrated circuit having a 3-state inverter (52) with first (58) and second inputs (60) and an output (62), said first input connected to said node of interest and said output connected to a common bus (55), said method comprising:
selectively providing an enabling signal to said second input (60) such that an analog signal at said node of interest is selectively transferred to said common bus (55) via said output;
connecting an amplifier circuit (54) to said common bus (55), said amplifier circuit having first (62) and second (64) amplifier inputs and an amplifier output (68), wherein said first amplifier input is connected to said common bus, said second amplifier input is connected to a reference and said amplifier output is connected to said common bus via a feedback path; and
accessing said analog signal at said amplifier output.

## Patentansprüche

1. Analog-Prüfbarkeits-Struktur zur Verwendung beim Prüfen von Analogsignalen in einer integrierten Schaltung, wobei die Struktur folgendes umfaßt:
einen einstufigen Spannungs-/Stromwandler (52) ohne Rückführung mit einem ersten Eingang (58) zum Empfang eines Analogsignals von einem interessierenden Knoten in der integrierten Schaltung, mit einem zweiten Eingang (60) zum Empfang eines Freigabesignals und mit Ausgangseinrichtungen (62) zur Lieferung eines Analog-Prüfsignalstromes, wenn dem zweiten Eingang ein Freigabesignal zugeführt wird,
einen gemeinsamen Bus (55), der mit den Ausgangseinrichtungen verbunden ist, und
eine Verstärkerschaltung (54), die mit dem gemeinsamen Bus verbunden ist und ein Prüf-Ausgangssignal (68) mit einem Strom liefert, der proportional zu dem Analog-Prüfsignalstrom ist,
dadurch gekennzeichnet, daß die Verstärkerschaltung so ausgebildet ist, daß sie den Bus auf einer im wesentlichen konstanten Spannung hält.

2. Struktur nach Anspruch 1,
bei der der Spannungs-/Stromwandler (52) ein Dreizustands-Wandler ist.

3. Struktur nach Anspruch 2,
die eine Vielzahl von Dreizustands-Invertern aufweist, die jeweils einen ersten Eingang zum Empfang von Analogsignalen von einer Vielzahl von interessierenden Knoten in der integrierten Schaltung aufweisen.

4. Struktur nach Anspruch 2,
bei der der Dreizustands-Inverter zwei Paare von komplementären MOS-Transistoren umfaßt, wobei ein Transistor des Paares Prüfdaten und der andere das Freigabesignal empfängt.

5. Struktur nach Anspruch 2,
bei der der Dreizustands-Inverter ein Paar von NMOS-Transistoren umfaßt.

6. Struktur nach Anspruch 2,
bei der der Dreizustands-Inverter ein Paar von PMOS-Transistoren umfaßt.

7. Struktur nach Anspruch 2,
bei der die Verstärkerschaltung ein Operationsverstärker (54) und ein Rückführungswiderstand (66) ist.

8. Struktur nach Anspruch 7,
bei der der Operationsverstärker einen ersten Eingang (62) zum Empfang der Analog-Prüfsignale, einen zweiten Eingang (64) zum Empfang eines Bezugssignals und einen Ausgang (68) zur Lieferung des Prüf-Ausgangssignals aufweist.

9. Struktur nach Anspruch 2,
bei der die Verstärkerschaltung auf der integrierten Schaltung angeordnet ist.

10. Struktur nach Anspruch 8,
bei der die Analog-Prüfsignale dem ersten Eingang über einen mit dem Bus verbundenen Eingangspfad zugeführt werden, wobei der Ausgang mit dem Bus über einen Rückführungspfad verbunden ist.

11. Struktur nach Anspruch 10,
bei dem der Eingangspfad und der Rückführungspfad an entgegengesetzten Enden des gemeinsamen Busses angeschlossen sind.

12. Struktur nach Anspruch 2,
die eine Vielzahl von Dreizustands-Invertern aufweist, wobei einer der Inverter ein Kalibriersignal zum Vergleich mit dem Analogsignal von einem interessierenden Knoten empfängt.

13. Struktur nach Anspruch 3,
die erste und zweite gemeinsame Bus-Anordnungen (116,118) und eine Differenzverstärkerschaltung (136) mit einem positiven Signaleingang, einem negativen Signaleingang und einem Differenzverstärkerausgang aufweist, wobei der Ausgang eines der drei Zustands-Inverter (112) mit der ersten gemeinsamen Bus-Anordnung (116) verbunden ist, während der Ausgang eines anderen der Dreizustands-Inverter (114) mit der zweiten gemeinsamen Bus-Anord-nung (118) verbunden ist, wobei die erste gemeinsame Bus-Anordnung mit dem positiven Signaleingang der Differenzverstärkerschaltung (136) verbunden ist und die zweite gemeinsame Bus-Anordnung mit dem negativen Signaleingang der Differenzverstärkerschaltung verbunden ist, so daß der Ausgang der Differenzverstärkerschaltung proportional zur Differenz zwischen dem Strom auf der ersten gemeinsamen Bus-Anordnung und dem Strom auf der zweiten gemeinsamen Bus-Anordnung ist.

14. Struktur nach Anspruch 3,
bei der erste und zweite Dreizustands-Inverter mit dem gemeinsamen Bus verbunden sind, wobei der erste Dreizustands-Inverter ein Analogsignal von einem ersten interessierenden Knoten empfängt und der zweite Dreizustands-Inverter ein Analogsignal von einem zweiten interessierenden Knoten empfängt, wobei beide Dreizustands-Inverter das gleiche Freigabesignal empfangen und der Ausgang der ersten und zweiten Inverter kombiniert wird, um eine arithmetische Summe der Analog-Prüfsignale zu erzeugen.

15. Struktur nach Anspruch 14,
bei der die ersten und zweiten Dreizustands-Inverter jeweils getrennte Kalibriereingänge aufweisen.

16. Struktur nach Anspruch 2,
bei der der Dreizustands-Inverter einen einzelnen NMOS-Transistor zwischen dem gemeinsamen Bus und einer Erdverbindung aufweist.

17. Struktur nach Anspruch 2,
bei der der Dreizustands-Inverter einen einzelnen PMOS-Transistor zwischen dem gemeinsamen Bus und einer positiven Versorgungsspannung aufweist.

18. Verfahren zum Zugriff auf ein Analogsignal an einem interessierenden Knoten in einer integrierten Schaltung, wobei die integrierte Schaltung einen Dreizustands-Inverter (52) mit ersten (58) und zweiten (60) Eingängen und einem Ausgang (62) aufweist, wobei der erste Eingang mit dem interessierenden Knoten verbunden ist und der Ausgang mit einem gemeinsamen Bus (55) verbunden ist, und wobei das Verfahren folgende Schritte umfaßt:
Selektives Zuführen eines Freigabesignals an den zweiten Eingang (60) derart, daß ein Analogsignal an dem interessierenden Knoten selektiv über den Ausgang an den gemeinsamen Bus (55) überführt wird,
Verbinden einer Verstärkerschaltung (54) mit dem gemeinsamen Bus (55), wobei die Verstärkerschaltung erste (62) und zweite (64) Verstärkereingänge und einen Verstärker-Ausgang (68) aufweist, wobei der erste Verstärkereingang mit dem gemeinsamen Bus verbunden ist, während der zweite Verstärkereingang mit einem Bezugswert verbunden ist und der Verstärkerausgang mit dem gemeinsamen Bus über einen Rückführungspfad verbunden ist, und
Zugreifen auf das Analogsignal an dem Verstärkerausgang.

## Revendications

1. Structure destinée à permettre des tests analogiques et à être utilisée pour le test de signaux analogiques dans un circuit intégré, la structure comprenant :
un convertisseur tension-courant (52) à un seul étage sans réaction, ayant une première entrée (58) destinée à recevoir un signal analogique d'un noeud intéressant incorporé au circuit intégré, une seconde entrée (60) destinée à recevoir un signal de validation, et un dispositif de sortie (62) destiné à transmettre un courant de signal de test analogique lorsqu'un signal de validation est appliqué à la seconde entrée,
un bus commun (55) connecté au dispositif de sortie, et
un circuit amplificateur (54) connecté au bus commun donnant un signal de sortie de test (68) ayant un courant proportionnel au courant du signal de test analogique, caractérisé en ce que le circuit amplificateur est destiné à maintenir le bus à une tension pratiquement constante.

2. Structure selon la revendication 1, dans laquelle le convertisseur tension-courant (52) est un inverseur à trois états.

3. Structure selon la revendication 2, comprenant plusieurs inverseurs à trois états ayant chacun une première entrée destinée à recevoir des signaux analogiques de plusieurs noeuds intéressants incorporés au circuit intégré.

4. Structure selon la revendication 2, dans laquelle l'inverseur à trois états comporte deux paires de transistors MOS complémentaires, un transistor de la paire recevant des données de test et l'autre le signal de validation.

5. Structure selon la revendication 2, dans laquelle l'inverseur à trois états comporte une paire de transistors NMOS.

6. Structure selon la revendication 2, dans laquelle l'inverseur à trois états comporte une paire de transistors PMOS.

7. Structure selon la revendication 2, dans laquelle le circuit amplificateur est un amplificateur opérationnel (54) avec une résistance de réaction (66).

8. Structure selon la revendication 7, dans laquelle l'amplificateur opérationnel possède une première entrée (62) destinée à recevoir les signaux de test analogiques, une seconde entrée (64) destinée à recevoir un signal de référence, et une sortie (68) destinée à transmettre le signal de sortie de test.

9. Structure selon la revendication 2, dans laquelle le circuit amplificateur se trouve sur le circuit intégré.

10. Structure selon la revendication 8, dans laquelle les signaux de test analogiques sont transmis à la première entrée par un trajet d'entrée connecté au bus, et la sortie est connectée au bus par un trajet de réaction.

11. Structure selon la revendication 10, dans laquelle le trajet d'entrée et le trajet de réaction sont connectés aux extrémités opposées du bus commun.

12. Structure selon la revendication 2, comprenant plusieurs inverseurs à trois états, l'un des inverseurs recevant un signal d'étalonnage destiné à être comparé au signal analogique provenant d'un noeud intéressant.

13. Structure selon la revendication 3, possédant un premier et un second bus commun (116, 118) et un circuit amplificateur différentiel (136) ayant une entrée de signal positif, une entrée de signal négatif et une sortie d'amplificateur différentiel, dans laquelle la sortie de l'un des trois inverseurs à trois états (112) est connectée au premier bus commun (116) et la sortie d'un autre des inverseurs à trois états (114) est connectée au second bus commun (118), le premier bus commun étant connecté à l'entrée de signal positif du circuit amplificateur différentiel (136) et le second bus commun étant connecté à l'entrée de signal négatif du circuit amplificateur différentiel, si bien que le signal de sortie du circuit amplificateur différentiel est proportionnel à la différence entre les courants du premier bus commun et du second bus commun.

14. Structure selon la revendication 3, dans laquelle le premier et le second inverseur à trois états sont connectés au bus commun, le premier inverseur à trois états recevant un signal analogique d'un premier noeud intéressant et le second inverseur à trois états recevant un signal analogique d'un second noeud intéressant, les deux inverseurs à trois états recevant le même signal de validation, et les signaux de sortie du premier et du second inverseur étant combinés pour la création d'une somme arithmétique des signaux de test analogiques.

15. Structure selon la revendication 14, dans laquelle le premier et le second inverseur à trois états ont chacun des entrées séparées d'étalonnage.

16. Structure selon la revendication 2, dans laquelle l'inverseur à trois états possède un seul transistor NMOS placé entre le bus commun et une connexion de masse.

17. Structure selon la revendication 2, dans laquelle l'inverseur à trois états a un seul transistor PMOS placé entre le bus commun et une alimentation positive.

18. Procédé d'accès à un signal analogique d'un noeud intéressant dans un circuit intégré, le circuit intégré possédant un inverseur à trois états (52) ayant une première entrée (58) et une seconde entrée (60) et une sortie (62), la première entrée étant connectée au noeud intéressant et la sortie étant connectée à un bus commun (55), le procédé comprenant :
la création sélective d'un signal de validation transmis à la seconde entrée (60) afin qu'un signal analogique du noeud intéressant soit transféré sélectivement au bus commun (55) par ladite sortie,
la connexion d'un circuit amplificateur (54) au bus commun (55), le circuit amplificateur ayant une première entrée (62) et une seconde entrée (64) d'amplificateur et une sortie (68) d'amplificateur, et la première entrée de l'amplificateur est connectée au bus commun, la seconde entrée de l'amplificateur est connectée à une référence et la sortie de l'amplificateur est connectée au bus commun par un trajet de réaction, et
l'accès au signal analogique à la sortie de l'amplificateur.
